Europäisches Patentamt

European Patent Office

Office européen des brevets

(19)

(11) Publication number: **0 129 707**
**B1**

(12) **EUROPEAN PATENT SPECIFICATION**

(45) Date of publication of patent specification: 24.02.88

(51) Int. Cl.⁴: **H 01 L 29/82**

(21) Application number: **84105752.4**

(22) Date of filing: **21.05.84**

(54) **Magnetically sensitive semiconductor devices.**

(30) Priority: **27.05.83 US 499101**

(43) Date of publication of application:
**02.01.85 Bulletin 85/01**

(45) Publication of the grant of the patent:
**24.02.88 Bulletin 88/08**

(84) Designated Contracting States:
**DE FR GB IT**

(56) References cited:
**US-A-3 167 663**

**IEEE TRANSACTIONS ON ELECTRON DEVICES
vol. ED-28, no. 3, March 1981, New York, USA
A. MOHAGHEGH et al."Double-Injection
phenomena under magnetic field in SOS films:
a new generation of Magnetosensitive
microdevices", pages 237-242**

**ELECTRONICS INTERNATIONAL, vol. 55, no.
10, May 1982, York, USA R. BERESFORD
"Magnetic transistors exploit new theory of
cairrier modulation", pages 45,46**

(73) Proprietor: **International Business Machines
Corporation
Old Orchard Road
Armonk, N.Y. 10504 (US)**

(72) Inventor: **Vinal, Albert Watson
810 Queensferry Rd.
Cary, NC 27511 (US)**

(74) Representative: **Klein, Daniel Jacques Henri
Compagnie IBM France Département de
Propriété Intellectuelle
F-06610 La Gaude (FR)**

(56) References cited:
**JOURNAL OF APPLIED PHYSICS, vol. 28, no. 2,
February 1957 New York, USA C. WURST et al.
"Rectification properties of metal-silicon
contacts", pages 235-240**

## Description

This invention relates to magnetically sensitive semiconductive devices, and more particularly to new magnetically sensitive semiconductive devices having Schottky barrier junctions.

A variety of known works on semiconductive magnetically sensitive devices exist. For example, a typical magnetically sensitive semiconductive device of the prior art is described in an article entitled "Magnetic transistors exploit new theory of carrier modulation", by R. Beresford and published in Electronics, May 19, 1982, pages 45 and 46. The device is of the lateral type with isotropic carrier injection at the emitter base junction, as a result such a device has a relatively poor signal to noise ratio and a limited frequency response.

So there still exists a present need for an improved magnetically sensitive semiconductive device.

The invention as claimed is intended to provide an improved magnetically sensitive semiconductor device having uniplanar minority carrier Schottky injection at an emitter or cathode. The invention is also intended to provide an improved semiconductive magnetically sensitive device having high frequency operating characteristics.

To the best of the applicant's knowledge, there are no presently known devices or teachings describing the use of Schottky barrier technology in magnetic transducers. This is believed to have occurred because Schottky barriers are normally formed on N-type silicon; in that case, the metal work function is greater than that of silicon and the Schottky barrier will conduct majority carrier electrons, while the concept of Lorentz modulation of emitter injection requires the injection of minority carriers instead of majority carriers.

In the Lorentz modulation of emitter injection the desirability exists of limiting injection to a single plane or surface. Further, in order to achieve higher frequency capabilities, it is necessary to place the emitter in close proximity to the collectors or a cathode in close proximity to the anodes. This, however, has an adverse effect on signal to noise ratio and sensitivity. The effect is produced by the unwanted injection around the perimeter of implanted emitters or cathodes. This problem might be solved by means such as barrier diffusions or implantations. However, it has been desired to achieve the necessary uniplanar emitter surface without the necessity of the somewhat more complex techniques.

The foregoing and other objects unenumerated are met in the present invention by providing a Schottky barrier junction as an emitter or cathode for a semiconductive transistor or diode, respectively. The Schottky barrier is preferably constructed using hafnium, zirconium, zinc, or any similar material that can form a silicide layer at the surface of P-type silicon substrates and having a work function potential $\phi_n$ less than 4,8 volts. Because no unwanted perimeter injection exists from the Schottky barrier, i.e., it is a uniplanar, unidirectional injection source, it is not necessary to remove the collectors or anodes to a distance more widely separated from the source of minority carriers in order to emphasize the contribution of those carriers injected in the desired direction. Instead, since the carriers may all be injected in the desired vertical direction for maximum sensitivity to magnetic flux directed parallel to the surface of the substrate, the collectors or anodes can be brought very close to the emissive surface. This, in turn, leads to a high frequency capability due to the short carrier transit times. Both vertical and lateral diode and transistor structures are possible and have been constructed as shown herein.

Figure 1A illustrates a plan view of a magnetically sensitive Schottky barrier junction lateral transistor according to the invention.

Figure 1B illustrates a sectional elevation view of the structure shown in Figure 1A.

Figure 2 illustrates a plan view of a lateral transistor according to the invention.

Figure 3 illustrates a plan view of a magnetically sensitive Schottky barrier contact diode according to the invention.

Figure 4A illustrates a plan view of a vertically structured magnetically sensitive transistor according to the invention.

Figure 4B illustrates a sectional elevation view of the structure shown in Figure 4A.

Figure 4C illustrates another sectional elevation view of the structure shown in Figure 4A.

Figure 5 illustrates a plan view of a magnetically sensitive Schottky barrier lateral diode according to the invention.

Figure 6 illustrates a plan view of a magnetically sensitive Schottky barrier lateral transistor according to the invention.

The fact that Schottky barrier injecting sources can be constructed is obscure, but a known reference is by E. C. Wurst, Jr. and E. C. Borneman appearing in the Journal of Applied Physics, Vol. 28, No. 2, pgs. 235—240, Feb. 1957. This work describes the rectifying capabilities of various metals in contact with both P and N-type silicon. The capability of minority carrier injection from a Schottky barrier, while not disclosed in this reference, is clearly supported by the findings of conduction and injection from various metal contacts with the noted substrates in this work.

The applicant has discovered that by proper choice of contact metal, and the use of P-type silicon substrates, strongly injecting Schottky barrier contact junctions can be formed which serve admirably for the purpose of uniplanar injection sources for magnetically sensitive devices as described herein.

The metals hafnium, zirconium, and zinc form appropriate silicides with silicon substrates when a heat treatment is carried out. The heat treatment is generally known in the art and will not be described in detail herein. Briefly, it consists in heating the substrate on whose surface has been deposited the appropriate metal in the desired areas to a temperature approximating 538°C until a metallic silicide is formed at the junction between the two materials.

The barrier potential ($\phi_s - \phi_m$) for hafnium silicide that provides a reliable Schottky barrier is approximately a negative 0,95 volts at room temperature. Zirconium and zinc also have a suitable Schottky barrier potential of approximately negative 0.8 volts and negative 0.53 volts, respectively, at room temperature. The other elements also form suitable barriers but are less desirable insofar as they are presently understood.

Base or anode ohmic output contacts can be made using ordinary aluminum for example, but Schottky barrier contacts of the desired metal can also be used. It is only necessary that a good ohmic base contact or anode contact be made. This can be achieved by heavily doping a P-region in the substrate in the area in which the aluminum is to make ohmic contacts for the collector or anode outputs.

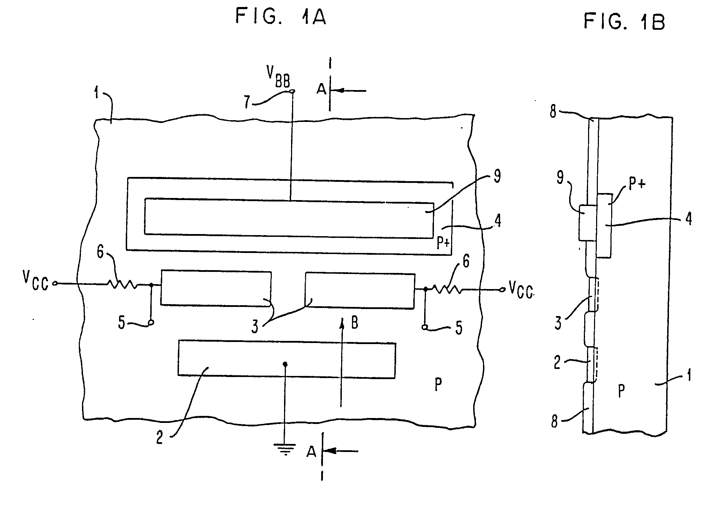

Turning to Figure 1, a form of a Schottky barrier magnetically sensitive transistor is illustrated in Figures 1A and 1B. In Figure 1A, a plan view with the overlying oxide coating of the semiconductive substrate removed for clarity is shown. Semiconductive substrate 1 is supplied with a metallic rectifying emitter contact 2. Preferably hafnium metal is used and a heat treatment as mentioned above is performed to create a hafnium silicide layer at the junction between the substrate 1 and the emitter metal 2. Two hafnium metal collectors with similar silicide barrier layers are deposited as collectors 3. The collectors are spaced on either side of an imaginary plan constructed perpendicular to the emissive surface and passing through the Lorentz potential null line of the emitter area. This concept, which utilizes the effect of the induced Lorentz potential that occurs when carriers intercept a magnetic field is described in previous documents, such as papers appearing in the IEEE Electron Device Letters, Vol. 3, No. 8, Aug. 1982 and in the IEDM Transactions, Dec. 1982. For purposes of this description, it suffices to say that the Lorentz potential which is induced modulates emitter injection or cathode injection. This will be briefly described as follows.

In Figure 1A, the hafnium emitter junction is forward biased by applying a positive voltage $V_{BB}$ to the base contact 9 while grounding the emitter contact 2. Base contact 9 can be ordinary aluminum making only ohmic contact with the surface of the semiconductive substrate 1. P-type substrates make good ohmic contact with aluminum and, to achieve even better contact, a heavy doping P+ material in the vicinity of the base contact may be carried out. This is illustrated as the implanted area 4 with the actual aluminum contact shown as 9 in Figures 1A and 1B. Under the circumstances described, a quiescent current will be caused to flow in the collector circuit comprising the load resistors 6 to which voltage $V_{CC}$ is applied. This can be sensed at the output terminals 5. This current can be controlled by the base voltage applied to the base at terminal 7 in a known manner. The quiescent current of the reverse biased collector is essentially balanced at the outset, but may be imbalanced by applying a magentic field vector parallel to the surface of the emitter.

Preferably, the emitter injects all minority carriers in the same direction, in this case, directly into the substrate in a vertical manner. Thus, these carriers will intercept the magnetic flux vector at right angles and produce the maximum Lorentz potential along the bottom single plane of the emitter junction. The application of a magnetic field parallel to this plane modulates the forward bias voltage occurring at the emitter junction since the Lorentz potential is greater at one side of the emitter than at the other and increases injection toward the one side while suppressing it toward the other. A null line exists between the two extremes of the Lorentz voltage. In the example shown in Figure 1A, the effect is such that the left half Schottky emitter junction will inject more electrons than the right half. In P-type silicon substrates, electrons are the minority carriers as required for operation.

The emitted minority carriers stream toward the two spaced apart collectors 3 and are drawn off through the load resistors 6. This results in a differential collector current which can be sensed as a differential voltage between the output terminals 5. This occurs as a result of the left collector receiving an increase in minority carrier flow while the right collector experiences a decrease in minority carrier flow. The total emitter current remains unchanged.

The structure in Figure 1A is further described with reference to the sectional elevational view along line AA which is depicted in Figure 1B.

In Figure 1B, the P-type silicon substrate 1 is provided with a general overall silicon dioxide insulator coating 8 which was removed for clarity in Figure 1A. Windows are opened up through etching, after an appropriate mask step, to provide areas for deposition of hafnium emitter metal 2, collector metal 3, the implantation of the P+ base contact area 4 and the application of the aluminum base contact 9. A heating process as previously alluded to is then carried out which creates the metal silicide barrier junction for Schottky barrier operation of the emitter and collectors. P-type silicon, preferably with a resistivity greater than 2 ohm centimeters, is employed. A Schottky—P silicon—Schottky (SPS) transistor configuration is thus described. The SPS magnetically sensitive transistor has a distinct advantage over NPN junction transistors. In fact, the Schottky barrier junction transistor is simple to fabricate and is completely free of the unwanted lateral minority carrier injection that normally will occur around the perimeter of a diffused or implanted emitter or cathode.

Perimeter injection is undesirable since this leads to a reduction in sensitivity for the desired magnetic field components and will account for a magnetic sensitivity to field components directed other than in the desired direction. If fields other than that preferred are employed, sensitivity to flux in unwanted directions cannot be distinguished at the output from that which is desired.

If it is desired to use the Schottky barrier transistor as a sensor in mass disc storage systems, for example, the sensor height and length will be typically 1.0 and 4.0 micrometers, respectively. The mounted and packaged sensor must also be brought close to the magnetically recorded medium. Consequently, a grinding and lapping process will ordinarily be carried out that may come close to an edge of the emitter part and actually lap away a portion of it. Unlike a PN junction emitter, the Schottky junction is essentially unaffected by a removal of a small portion along its edge.

Magnetically sensitive Schottky diodes and transistors depend on minority carrier injection. The injected minority carriers reduce conductivity in the region between the emitter or cathode and the output base, collector or anodes. A high level injection of minority carriers with base resistivities in excess of 2 ohm centimeters can satisfy the desired criteria.

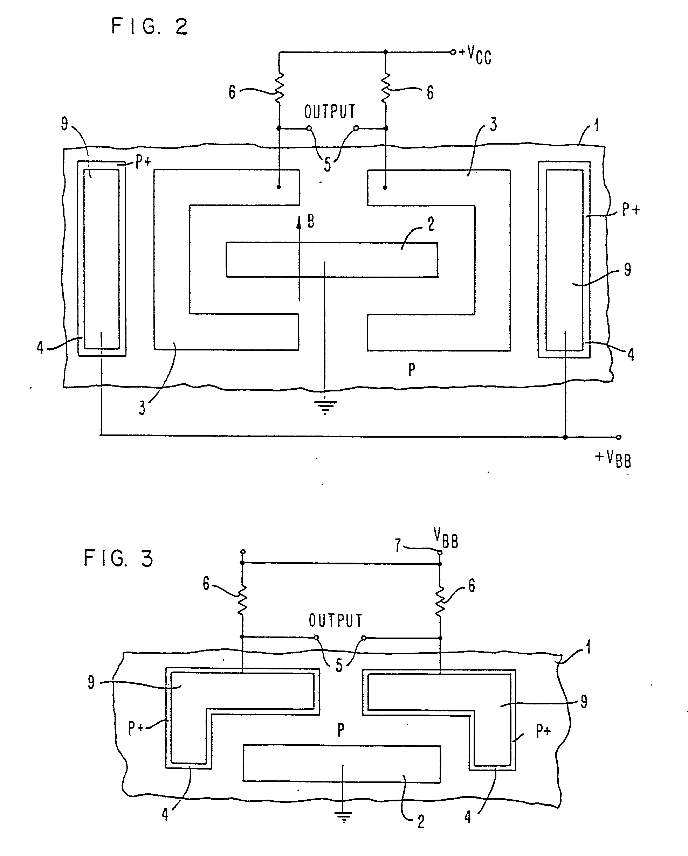

Figure 3 illustrates a magnetically sensitive Schottky barrier diode formed using hafnium, zirconium or zinc metal contacts as the cathode 2 in contact with a P-type silicon substrate 1. The magnetic field is, as in the previous Figure 1, oriented parallel to the surface of the junction such that modulation of injection across the junction will take place when the magnetic field is present. The preferential injection of minority carriers from the emissive surface of the cathode (or emitter) 2 will result in modulation of the anode (or base) conductivity that will lead to a differential output voltage measured at the output terminals 5 connected to the anode contacts 9 which through load resistors 6 are connected to the $V_{BB}$ voltage present at terminal 7. Like in Figure 1, a heavy doped P+ material 4 may be present in the vicinity of the anode contact.

The expression defining the differential current ΔI that will flow in the diode shown in Figure 3 is given by the following equation:

$$\Delta I = \frac{V_j}{R_L + Rbo + \Delta Rbo} \left\{ \frac{Io\ Rbo\ Ln}{Kt/q\ Leb} \left[ \frac{1}{1 + \dfrac{NA}{N'(O)} \cdot \dfrac{\mu_p}{\mu_p + \mu_n}} - \frac{1}{1 + \dfrac{NA}{N'(O)} \cdot \dfrac{\mu_p}{\mu_n + \mu_p} e^{Leb/Ln}} \right] \right\} \qquad \text{Eq. (1)}$$

where:

$\Delta V_j$ = Lorentz voltage modulation at junction
Rbo = Quiescent base resistance
Io = Quiescent forward bias current
Ln = Minority carrier electron diffusion length
N'(O) = Excess minority carrier concentration injected at junction
Leb = Distance between emitter and base contact
NA = Number of acceptor atoms
$\mu_p$ = Hole mobility
$\mu_n$ = Electron mobility
RL = Load resistance

Turning to Figure 2, a different magnetically sensitive lateral Schottky barrier transistor configuration is shown in plan view. In Figure 2, the collectors 3 are relatively C-shaped and surround the ends of the metal emitter 2. However, the collectors 3 still reside on opposite sides of an imaginary plane passing through the Lorentz voltage null and perpendicular to the emissive surface as required for proper operation. The other elements are similarly numbered for the same purpose and function as that described with reference to Figures 1A and 1B.

Placing the ohmic base contacts 9 at a symmetrically spaced distance relative to the emitter and the collectors results in attracting the minority carriers toward the direction of each collector to maximize collection of injected carriers. This enhances the overall sensitivity of the device. A signal output will be measured between the collector Schottky barriers 3 which also employ hafnium metal in the preferred embodiment as shown. The magnetic field vector B is shown in Figure 2 as parallel to the bottom surface of the emitter so that the maximum Lorentz potential modulation of the emitter injection will occur as described in my aforementioned references.

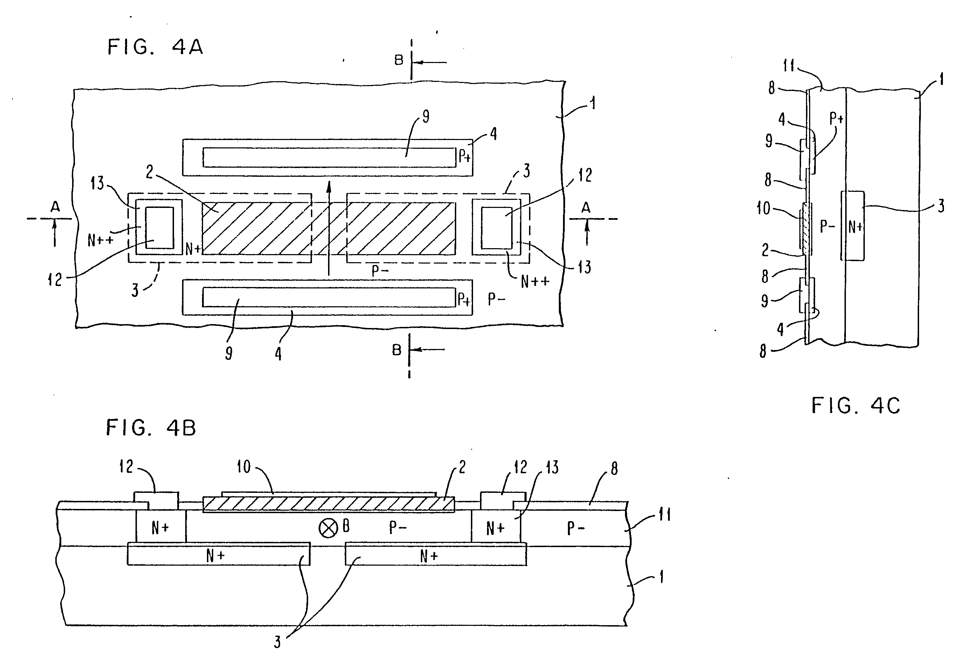

Turning to Figure 4, a vertically oriented structure of this invention will be described. In all of the structures described thus far, and in those which will be described with reference to Figure 4, it is necessary to realize that the collector contacts need not be Schottky barrier elements. Indeed, hybrid transistors and

4

diodes where the emitters or cathodes, for example, use a Schottky barrier junction can be built with collectors or anodes having normal diffused junctions with aluminum metal contacts or the like.

Turning to Figures 4A—4C, a vertical Schottky barrier injection magnetically sensitive transistor is shown. In Figure 4A, a plan view of the elements in their arrangement on a semiconductive substrate 1 is shown. The Schottky emitter 2 is positioned on a top surface and directly above the two spaced apart collectors 3. Collector contacts 12 contact N+ doped regions which are diffused deeply to make contact with the N+ doped collectors located beneath the emitter; output terminals (not shown) like terminals 5 in Figure 1 are connected to collector contacts 12. The metallic base contact 9 makes contact with P+ doped base regions 4 since aluminum makes good ohmic contact with P+ material. N+ material also allows for good ohmic contact but this material is avoided here to prevent the creation of rectifying contacts at these points.

Figure 4B shows a horizontal sectional elevation view along line AA in Figure 4A. It will be observed that the Schottky emitter 2 is provided with an aluminum top ohmic contact 10. The oxide layer 8 is shown in Figure 4B with windows opened up for the aluminum contact 12 and the Schottky emitter 2. This structure is built in a somewhat different fashion. First, a semiconductor substrate 1, which may be either P or intrinsic material for these purposes and is not an active part of the structure, is implanted with the collector regions 3. These are heavily N+ doped with arsenic, for example. These regions lie in the top region of the semiconductive substrate 1. Next, an epitaxial layer 11 of a P— semiconductor material is laid down over the entire semiconductive substrate 1 and the collectors 3. Next, a heavy doping of phosphorous for example, which can be implanted or diffused to relatively great depths, is provided in region 13 to make contact with the N+ doped collectors from the top surface of the P— epitaxial layer. Next, the oxide layer 8 will be grown or deposited and then an etching step is carried out to open up the contact windows for the aluminum contacts 12 for the collectors, for the base contacts 9, and in the region for the Schottky barrier emitter 2. The metal depositions for the Schottky barrier and for the contacts are then made.

Figure 4C illustrates another sectional view BB through an end elevation of the structure shown in Figure 4A. It may be observed that the collectors 3 are directly beneath the emitter Schottky barrier 2 and are separated by the relatively thin P— layer 11. This means that the emissive surface of the Schottky barrier 2 is directly aligned with the collector surfaces 3. Lorentz modulation of emitter injection occurs at the Schottky barrier and will supply current more heavily to one collector 3 than the other depending on the direction of a magnetic flux vector. The most sensitive direction for interaction is when the magnetic flux vector passes parallel to the substrate and the emissive surface so as to be perpendicular to the direction of travel of the injected minority carriers.

These structures exhibit the highest frequency response, that extends well into the gigahertz range. In addition, they are extremely linear and have a high signal to noise ratio with little or no unwanted components due to injection from other than the desired uniplanar injection surface.

The Schottky barrier technology also provides an opportunity for creating magnetically sensitive diodes and transistors without diffusions or implantations into the substrate.

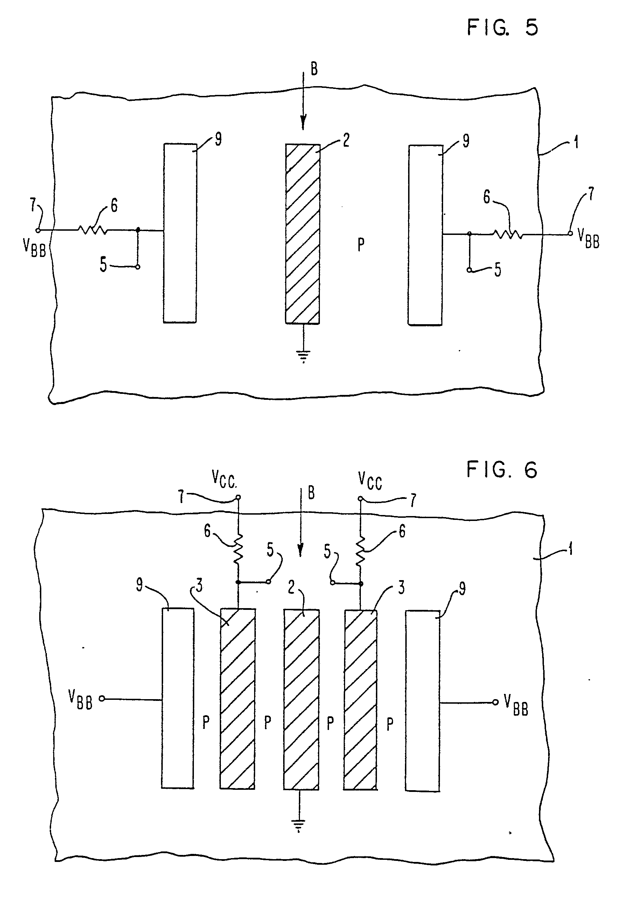

For example, Figure 5 illustrates a plan view of a Schottky barrier diode that is magnetically sensitive. The substrate 1 and the emitter or cathode 2 are constructed as explained above. The cathode 2 is a rectifying contact Schottky barrier junction. The base or anode contacts are ohmic contacts 9, which have output terminals 5 and are connected through load resistors 6 to voltage source $V_{BB}$ at terminals 7. It may be observed that the base and emitter are all in the same plane, do not require diffusions or implantations and are easily constructed. The magnetic vector B is also shown in Figure 5. It is directed parallel with the substrate 1 and the emissive surface of the cathode 2. It could be directed at right angles in the plane of the paper or at any other direction within the plane of the paper and still remain perpendicular to the vertically injected minority carriers issuing from the bottom surface of the emitter 2 downward into the substrate 1. The Lorentz potential will be developed at right angles to the magnetic vector and, in the case illustrated in Figure 5, along the shorter axis of the emitter 2. The null of the Lorentz potential will be on the center line or longitudinal axis of emitter 2 and it may be seen that the imaginary plane constructed perpendicular to the emissive surface and passing through the null of the Lorentz potential will also lie along this axis.

The base or anode contacts in the case of a diode and collector contacts and base contacts in the case of a transistor will be located as described above on opposite sides of this imaginary plane. By making the base or anode contacts uniplanar and coplanar with the emitter, several important attributes result. First, it is easy to vary the distance or spacing between the contacts and the emitter. For example, an experimental structure with numerous base contacts spaced at different distances from the emitter can be constructed and then the base contacts of greatest signal output can be utilized. There is an important dependence upon the distance between the base or anode contact and the emitter and it will be instantly appreciated that the farther the contacts are removed from the emitter, the more minority carriers will be subject to recombination in substrate 1. This will reduce the overall signal output. Secondly, it is much easier to make good ohmic contact and supply a high quality diode function than it is to make consistently controlled high quality diffusion contacts and still avoid the creation of rectifying junctions at the output contacts. This is a problem familiar to those acquainted with solid state semiconductor devices and needs no further description, the point being that exceptionally high quality diodes are manufactured in this manner with pure ohmic contact. Thirdly, by placing all of the contacts and elements on one surface, it is possible to create a magnetically sensitive structure that can be brought to a very thin finished depth so that it may be put in service at close proximity to a magnetic medium with field vectors in the appropriate direction as shown by vector B in Figure 5 for example.

Figure 6 illustrates in schematic plan view a magnetically sensitive transistor having in substrate 1 a Schottky barrier emitter 2, two ohmic base contacts 9 connected to voltage source $V_{BB}$, and two spaced apart rectifying collectors 3 which have output terminals 5 and are connected through load resistors 6 to voltage source $V_{CC}$ at terminals 7. It will be observed that the structure is similar to that in Figure 5 with the exception that rectifying collectors have been added between the base contacts and the emitter. The placement of the collector between the bases and the emitter and in the same plane as the emitter is important for the reasons noted with respect to the diode but also is easily constructed for the same reasons as well.

The collectors 3 in Figure 6 are preferably the rectifying Schottky barrier contacts similar to the emitter 2. However, doped diffusions or implantations can also be utilized in a hybrid form of this transistor. It will be observed that in Figure 6 and Figure 5 as well, the base or anode contacts and the collector contacts as well, when present, are located on opposite sides of said imaginary plane and parallel therewith with the collectors spaced closer to the emitter than are the base contacts. This placement of the elements relative to one another enhances the effect of the Lorentz modulation of emitter injection by encouraging the minority carrier flow to occur directly between the emitter and the collectors or anodes. This means that virtually all carriers which are emitted will take part in and add to the eventual differential output signal, which equates to a high overall transduction efficiency.

It will be observed that the alignment of the various elements on a common axis, horizontal in the case of Figure 6, provides straight line paths for all emitted carriers with no off-axis disturbances due to physical necessity of locating base contacts and other areas which are present in other structural implementations of this invention. The position of the base contact relative to the emitter has an important effect on encouraging the desired direction of carrier injection and on limiting or reducing unwanted noise components. It has been found that the most desirable placement of the elements is parallel with said imaginary plane, as shown in the Figures 5 and 6, and most desirably just in the same plane as depicted in these figures. However, vertically integrated structures described earlier still maintain the parallelism and achieve the highest frequency response and transduction efficiencies for the reasons discussed relative thereto.

Relative to both Figures 5 and 6, it will be observed that the orientation of the emitter surface relative to the magnetic flux vector B is such that the device will be most sensitive to flux components directed along a vertical Y axis in the plane of the paper. Lorentz modulation of emitter injection will be most pronounced along the edges or long axes of the emitters 2 in these figures. It is possible, given these considerations, to envision an array of such sensors on a single substrate with the array oriented at precise angles for the purpose of analyzing a magnetic flux field as to direction in density and the like. A digital magnetic compass can thus be rather easily constructed from a plurality of such sensors on a single substrate for example. As will be evident to those of skill in the art, numerous configurations are possible and this, combined with the ease of varying the position of the base contacts relative to the collectors and the emitter and to the ease of constructing such uniplanar devices as alluded to above, will readily suggest numerous variations and configurations depending upon the specific application to which the sensor is directed.

Having thus described the invention with reference to several embodiments thereof, it will be obvious to those of skill in the art that numerous changes in structure, manufacturing procedure, doping elements, thickness, dimensions, orientation and arrangement of the elements and the like may be performed without departing from the basic scope of the invention, as defined in the claims.

## Claims

1. Magnetically sensitive semiconductor device having a semiconductor substrate (1), an emitter (2) forming a junction with the substrate and at least two output contacts (3 in Figures 1, 2, 4, 6; 9 in Figures 3, 5) on said substrate, one of which is on one side of an imaginary plane constructed perpendicular to a surface of said junction and passing through the Lorentz potential null thereon, characterized in that (1) said junction is a Schottky barrier junction which is biased to inject minority carriers into a P type substrate, from a single plane of injection, and (2) said output contacts having electrical potential supply connections (5) to provide an electrical output signal in response to magnetic fields intercepting the substrate parallel to the surface of said Schottky barrier junction.

2. Magnetically sensitive semiconductive device as claimed in Claim 1, wherein said two output contacts are located on opposite sides of said imaginary plane.

3. Magnetically sensitive device as claimed in Claims 1, 2 wherein said Schottky barrier junctions are formed with hafnium, zirconium or zinc metal on a silicon P-type substrate.

## Patentansprüche

1. Magnetisch empfindliche Halbleitervorrichtung mit einem Halbleitersubstrat (1), einem Emitter (2), die mit dem Substrat einen Zonenübergang an mindestens zwei Ausgangskontakten auf dem besagten Substrat bilden (3 in den Abbildungen 1, 2, 4, 6; 9 in den Abbildungen 3, 5), von denen einer auf einer Seite einer gedachten Ebene, senkrecht zu einer Fläche der besagten Übergangszone, und durch das daran anliegende Lorentz-Nullpotential führt, dadurch gekennzeichnet, dass die besagte Übergangszone eine Schottky-Barriere-Zone ist, mit einer Vorspannung, um Minoritätsträger aus einer einzigen Injektionsebene in einem Substrat vom Typ P anzulegen, und dadurch, dass (2) besagte Ausgangskontakte Anschlüsse an eine elektrische Potentialversorgung (5) haben, um ein elektrisches Ausgangssignal abzugeben, das auf die magnetischen Felder anspricht, welche das Substrat parallel zur Fläche der besagten Schottky-Barrier-Übergangszone abfangen.

2. Magnetisch empfindliche Halbleitervorrichtung gemäss Anspruch 1, in der sich die besagten beiden Ausgangskontakte auf den entgegengesetzten Seiten der besagten gedachten Ebene befinden.

3. Magnetisch empfindliche Vorrichtung gemäss Anspruch 1 und 2, in der besagte Schottky-Barriere-Übergangszonen mit Hafnium, Zirkonium oder Zink auf einem Silikonsubstrat vom Typ P gebildet werden.

**Revendications** .

1. Dispositif semiconducteur sensible au champ magnétique, comportant un substrat semiconducteur (1), un émetteur (2) formant une jonction avec le substrat et au moins deux contacts de sortie (3 sur les figures 1, 2, 4, 6; et 9 sur les figures 3, 5) sur ledit substrat, l'un desquels se trouve d'un côté d'un plan imaginaire perpendiculaire à une surface de ladite jonction traversant la ligne de potentiel de Lorentz nul sur celle-ci, caractérisé en ce que (1) ladite jonction est une barrière de Schottky polarisée de façon à injecter des porteurs minoritaires dans un substrat de type P, depuis un unique plan d'injection, et (2) lesdits contacts de sortie possèdent des connexions (5) avec une source de potentiel électrique afin de produire un signal électrique de sortie en réponse à des champs magnétiques interceptant le substrat parallèlement à la surface de ladite jonction à barrière de Schottky.

2. Dispositif semiconducteur sensible au champ magnétique selon la revendication 1, caractérisé en ce que les deux contacts de sortie sont situés de part et d'autre dudit plan imaginaire.

3. Dispositif semiconducteur sensible au champ magnétique selon les revendications 1, 2, caractérisé en ce que lesdites jonctions à barrière de Schottky sont en hafnium, en zirconium ou en zinc et formées sur un substrat en silicium de type P.

FIG. 1A

FIG. 1B

FIG. 2

FIG. 3

FIG. 4A

FIG. 4B

FIG. 4C

FIG. 5

FIG. 6